# EUROPÄISCHE PATENTSCHRIFT

(11) **EP 2 823 545 B1**
(45) Veröffentlichungstag und Bekanntmachung des Hinweises auf die Patenterteilung: **09.05.2018**
(21) Anmeldenummer: 13707394.6
(22) Anmeldetag: 05.03.2013
(51) Int. Cl.: H02H 9/04, H02H 3/04, G01R 1/07, G01R 1/20, G01R 1/36, G06K 19/07, G01R 19/00

(54) **SCHALTUNGSANORDNUNG ZUR ZUSTANDSKONTROLLE UND PROTOKOLLIERUNG VON ÜBERSPANNUNGSSCHUTZGERÄTEN ODER ÜBERSPANNUNGSSCHUTZANLAGEN**
CIRCUIT ASSEMBLY FOR THE STATE MONITORING AND LOGGING OF OVERVOLTAGE PROTECTION DEVICES OR OVERVOLTAGE PROTECTION SYSTEMS
CIRCUITERIE POUR CONTRÔLER L'ÉTAT ET ÉTABLIR UN COMPTE RENDU SUR DES APPAREILS DE PROTECTION CONTRE LES SURTENSIONS OU INSTALLATIONS DE PROTECTION CONTRE LES SURTENSIONS

(30) Priorität: 07.03.2012 DE 102012004716
(43) Veröffentlichungstag der Anmeldung: 14.01.2015
(73) Patentinhaber: DEHN + SÖHNE GMBH + CO. KG, 92318 Neumarkt (DE)
(72) Erfinder: MOOSBURGER, Benjamin, 92358 Seubersdorf (DE); IGL, Peter, 90602 Pyrbaum (DE); BOEHM, Thomas, 92366 Hohenfels (DE); HEROLD, Hans, 92334 Berching (DE)
(74) Vertreter: Kruspig, Volkmar
(86) Internationale Anmeldenummer: PCT/EP2013/054377
(87) Internationale Veröffentlichungsnummer: WO 2013/131897

(56) Entgegenhaltungen:
- EP-A2- 0 463 860
- EP-A2- 0 915 345
- DE-A1-102006 018 471
- DE-B3-102004 006 987
- US-A1- 2006 082 942

## Beschreibung

Die Erfindung betrifft eine Schaltungsanordnung geeignet für eine Zustandskontrolle und Protokollierung von Überspannungsschutzgeräten oder Überspannungsschutzanlagen mittels Impulsstromüberwachung, umfassend mindestens einen passiven RFID-Transponder mit induktiv gekoppelter Spannungsversorgung, wobei im Ereignisfall des Überspannungsschutzgeräts oder der Überspannungsschutzanlage der RFID-Transponder-Antennenkreis beeinflusst, insbesondere unterbrochen, kurzgeschlossen oder verstimmt wird, so dass Störvorgänge identifizierbar sind, gemäß Patentanspruch 1.

Aus der WO 2011/058318 A1 ist eine Sensoranordnung bekannt, um schnelle transiente Strombelastungen in Überspannungsschutzgeräten zu registrieren und die Anzahl der Stromimpulse in einer Auswerteeinrichtung zu speichern. Über die Anzahl der registrierten Impulse wird eine Bewertung des Zustands des Überspannungsschutzgeräts vorgenommen. Bei der Messeinrichtung nach DE 10 2008 016 585 A1 wird der Spannungsverlauf an einem Überspannungsschutzgerät erfasst und mittels Diagnoseein-richtung bewertet. Über die Merkmale des Spannungsverlaufs, wie Amplitude, Steigung, Spannungswertebereich und Zeit wird der Funktionszustand der Schutzeinrichtung klassifiziert. Falls die Merkmale vorbestimmten Kriterien nicht genügen, wird die Schutzvorrichtung als nicht funktionsfähig erkannt.

Eine Wiederholung der Zustandskontrolle in vorbestimmten Zeitabschnitten wird nach er DE 10 2008 016 589 A1 gelehrt. Das funktionsunfähige Schutzelement wird deaktiviert und es erfolgt ein Umschalten auf ein Ersatzelement. Über eine Anzeigeeinrichtung oder einen Melder wird der Fehlerzustand signalisiert.

Bei der DE 10 2008 025 501 A1 ist eine Anzeigeeinrichtung, ausgeführt als Sicherung offenbart, die in einen Ableitpfad eines Überspannungsschutzgeräts geschaltet ist. Bei Auslösen der Sicherung wird der Schaltungszweig abgetrennt, wobei ein parallel geschalteter zweiter Ableitpfad weiterhin In Funktion bleibt.

Zur Erfassung von Stoßströmen an Leitern und Überspannungsschutzgeräten ist gemäß DE 38 23 389 C1 eine Lösung vorbekannt, bei welcher das durch den Stoßstrom erzeugte magnetische Feld Daten, die auf einem magnetisierbaren Datenträger abgelegt sind, verändert, insbesondere gelöscht werden. Aus den auf dem Datenträger verbleibenden Daten kann dann die Intensität des Stromereignisses indirekt ermittelt werden.

Die gattungsbildende DE 10 2004 006 987 B3 offenbart eine Anordnung zur Zustandskontrolle und Protokollierung von Überspannungsschutz-Geräten, insbesondere bei deren Einsatz in Niederspannungsnetzen oder der Informationstechnik.

Gemäß dieser Lösung ist in einem Gehäuse mit dem Überspannungsschutzgerät baulich vereint eine Fehlererkennungseinheit vorhanden, wobei die Fehlererkennungseinheit über einen im Gehäuse befindlichen RFID-Transponder ausles- und abfragbar ist.

Der dortige Transponder, der den eigentlichen Datenträger des RFID-Systems darstellt, besteht üblicherweise aus einem Koppelelement sowie einem Mikrochip. Als passiver Transponder ist dabei keine eigene Energieversorgung vorhanden. Die gesamte Energie zum Betrieb des passiven Transponders wird dem elektrischen oder magnetischen Feld des Lesegeräts entnommen. Bei der Ausführung des RFID-Transponders als passiver Transponder mit induktiv gekoppelter Spannungsversorgung sowie vorhandener Identifikationsschaltung mit Speicherfunktion, welche herstellungs- und anwendungsspezifische Informationen sowie Prüf- und Kenndaten enthält, wird im Fehlerfall gemäß DE 10 2004 006 987 B3 des Überspannungsschutzgeräts die Fehlererkennnungseinheit veranlasst, den Transponder-Antennenkreis kurzzuschließen oder zu unterbrechen. Alternativ kann durch Zu- oder Abschalten von Antennen-spulenwindungen oder Schwingkreiskapazitäten die Schwingkreisfrequenz gezielt verändert werden. Die Anordnung zur Zustandskontrolle wird über ein Handlesegerät abgefragt. Im Transponder-Speicherchip abgelegte Daten werden ausgelesen und es kann je nach Zustandskontrollergebnis ein Austausch des jeweiligen Überspannungsschutzgeräts vorgenommen werden.

Es existieren jedoch Einsatzfälle, wo eine Zustandskontrolle und Protokollierung von Überspannungsschutzgeräten oder Überspannungsschutzanlagen gewünscht wird, bei denen eine gezielte Überlastung des Antennenkreises des RFID-Transponderbausteins bzw. eines sonstigen relevanten Transponder-eingangs durch den fließenden Stoßstrom nicht möglich ist. Dies ist beispielsweise dann der Fall, wenn die RFID-Antennenspulenfläche zu gering ist, keine optimale Orientierung der Antenne zu den Feldlinien des Störmagnetfelds vorliegt oder aber die zu überwachenden Stoßströme zu klein sind, d.h. keine ausreichende Energie besitzen.

Aus der EP 0 915 345 A2 ist ein Überspannungsableiter mit einer Vorrichtung zur Anzeige eines Fehlerstromes vorbekannt. Bei dieser Lösung des Standes der Technik wird beim Auftreten eines durch den Überspannungsableiter fließenden Fehlerstroms ein Teil des Stromes in einen Stromleiter geführt oder im Stromleiter induziert, wodurch es zu einer Zerstörung des Stromleiters oder eines Informationsträgers kommt. Eine Lesestation empfängt ein Signal, welches den veränderten Zustand des Informationsträgers erkennt und damit den fehlerbehafteten Ableiter unabhängig von weiteren Bedingungen identifiziert.

Aus dem Vorgenannten ist es daher Aufgabe der Erfindung, eine weiterentwickelte Schaltungsanordnung geeignet für eine Zustandskontrolle und Protokollierung von Überspannungsschutzgeräten oder Überspannungsschutzanlagen mittels Impulsstromüberwachung anzugeben, welche von einem passiven RFID-Transponder mit induktiv gekoppelter Spannungsversorgung ausgeht, wobei im Ereignisfall des Überspannungsschutzgeräts oder der Überspannungsschutzanlage der RFID-Transponder-Antennenkreis beeinflusst wird, um Störvorgänge zu identifizieren. Aufgabengemäß soll die Beeinflussung des Transponder-Antennenkreises unabhängig von den Eigenschaften der diesbezüglichen RFID-Spule möglich sein, wobei auch zu berücksichtigen ist, dass üblicherweise die am Markt befindlichen Transponderbausteine eine höhere Spannungsfestigkeit an ihren Eingängen aufweisen.
Die Lösung der Aufgabe der Erfindung erfolgt durch eine Schaltungsanordnung gemäß der Merkmalskombination nach Patentanspruch 1, wobei die Unteransprüche zweckmäßige Ausgestaltungen und Weiterbildungen darstellen.
Erfindungsgemäß ist ein durch ein Impulsstrom-Magnetfeld auslösbarer reversibler Schalter bzw. eine entsprechende Schalteinrichtung vorgesehen, welche den RFID-Antennenkreis beeinflusst, insbesondere unterbricht.
In einer Ausgestaltung der Erfindung besteht die Möglichkeit, eine Bewertung der vorliegenden Impulsströme bzw. Stoßströme vorzunehmen, indem mehrere parallele Schalteinrichtungen vorhanden sind, die mit einem aufgeteilten Auslösestrom durch Vorschalten entsprechender Widerstände beaufschlagt werden. Jeder Schalteinrichtung ist ein eigener RFID-Kreis zugeordnet, wobei die RFID-Kreise nacheinander von einem Auswertegerät angesprochen und daraufhin überprüft werden, ob die im jeweiligen Transponder abgelegten Daten gelesen werden können. Aus dieser Information kann dann das Auswertegerät ausgelöste Schwellwertschalter, d.h. aktivierte Schalteinrichtungen ermitteln und eine Information über die auftretende oder aufgetretene Stoßstromgröße gewinnen.
Wird die Schalteinrichtung erfindungsgemäß als elektronischer Schalter, z.B. selbstleitender MOSFET ausgeführt, besteht die Möglichkeit, den RFID-Antennenkreis nur für eine bestimmte Zeit zu unterbrechen. Wird über eine entsprechende Auswerteeinrichtung eine kontinuierliche Abfrage des Transponders durchgeführt, kann eine Zähleinrichtung für das Auftreten von Störimpulsen realisiert werden. Hierfür ist dabei Sorge zu tragen, dass die Auswerteeinrichtung mit einem Abfrageintervall kleiner als die Zeitkonstante des elektronischen Schalters arbeitet.

Es wird beim Erfindungsgegenstand demnach von einer Schaltungsanordnung geeignet für eine Zustandskontrolle und Protokollierung von Überspannungsschutzgeräten oder -anlagen mit Impulsstromüberwachung ausgegangen, wobei die Schaltungsanordnung mindestens einen passiven RFID-Transponder mit induktiv gekoppelter Spannungsversorgung umfasst. Im Ereignisfall des Überspannungsschutzgerätes oder der Überspannungsschutzanlage wird der RFID-Transponderkreis beeinflusst, insbesondere kurzgeschlossen, unterbrochen oder verstimmt, so dass Störvorgänge identifizierbar werden.

Erfindungsgemäß ist an einer auftretende Impulsströme führenden Ableitung des Überspannungsschutzgerätes oder der Überspannungsschutzanlage eine Spule vorgesehen, welche derart orientiert ist, dass das Impulsstrom-bedingte Feld die Spulenwickelfläche durchdringt, wobei die Spule mit mindestens einer Schalteinrichtung in Verbindung steht, welche am Antennenkreis des RFID-Transponders mit der dortigen Induktivität angeschlossen ist, um den Antennenkreis mindestens zeitweise zu beeinflussen. Die vorerwähnte Spule arbeitet dabei völlig unabhängig von der eigentlichen Antennenkreisspule des Transponders und ist für die hier vorgesehenen Zwecke optimierbar.

Die Induktivität der den Antennenkreis des RFID-Transponders bildende Spule weist eine Orientierung auf, die sicherstellt, dass bei auftretenden Impulsströmen keine oder nur eine geringe Induktion gegeben ist.

Bei einer bevorzugten Ausführungsform steht die Impulsstrom-Spule mit einer Graetz-Gleichrichterbrücke in Verbindung, welche ausgangsseitig über eine Diode am Schaltelement bzw. der Schalteinrichtung angeschlossen ist, wobei das Schaltelement im Ausgangszustand den Antennenkreis des RFID-Transponders, umfassend die Antennenkreisspule und eine dortige Kapazität, geschlossen hält.

Im Falle eines Auslösens des Schaltelements wird eine Halbwelle der von der Spule des Antennenkreises erzeugten Spannung über die Gleichrichterbrücke und die vorerwähnte Diode gesperrt, so dass die Empfindlichkeit der RFID-Kommunikation beeinflusst, insbesondere reduziert ist.

Die Impulsstrom-Spule ist bevorzugt als Ringkernspule oder kernlose Luftspule, insbesondere Rogowski-Spule ausgebildet.

Erfindungsgemäß werden als Schaltelemente Transistoren, insbesondere MOSFETs eingesetzt und es besteht die Möglichkeit, den RFID-Antennenkreis nur für eine vorbestimmte Zeit zu beeinflussen, insbesondere zu unterbrechen. Nach einer einstellbaren Zeitkonstante wird der Antennenkreis wieder geschlossen und in den üblichen Arbeitszustand überführt. Durch diese Maßnahme kann eine Zähleinrichtung für das Auftreten von Impulsen realisiert werden, z.B. um die Registrierung eines Ableitstroms in einer Fangeinrichtung einer Blitzschutzanlage vorzunehmen.

Bei ausgelöster Schalteinrichtung besteht die Möglichkeit, durch eine erhöhte Kopplung zwischen einer Transponder-Leseeinrichtung und dem Antennenkreis eine Kommunikationsverbindung aufzubauen, um die im Transponder abgelegten Informationen auszulesen. Die Kopplung kann z.B. durch eine vergrößerte Sendeleistung mit dem Ziel der Datenübertragung zwischen Transponder und Lesegerät verbessert werden.

Die Erfindung soll nachstehend anhand von Ausführungsbeispielen und unter Zuhilfenahme von Figuren näher erläutert werden.

Hierbei zeigen:
- Fig. 1: ein Prinzipschaltbild einer nicht erfindungsgemäßen Ausführungsform zur Zustandskontrolle und Protokollierung von Überspannungsschutzgeräten mit einer Sicherung als Schaltelement oder Schalteinrichtung;
- Fig. 2: eine Prinzip-Schaltungsanordnung einer nicht erfindungsgemäßen Lösung mit einer Aufteilung der über die Spule L2 generierten Energie auf mehrere Schalteinrichtungen, insbesondere Sicherungen, zur einfachen Bewertung des im Leiter aufgetretenen Stoßstroms;
- Fig. 3: eine erfindungsgemäße Prinzip-Schaltungsanordnung mit einem elektronischen Schalter als Schalteinrichtung, mit dessen Hilfe für eine bestimmte Zeit der RFID-Antennenstromkreis unterbrochen werden kann, um eine Zähleinrichtung für das Auftreten von Impulsen zu realisieren, und
- Fig. 4: eine beispielhafte Anordnung der erfindungsgemäßen Impulsstrom-Spule und der RFID-Antennenkreisspule an einer Fangeinrichtung zur Überwachung dieser.

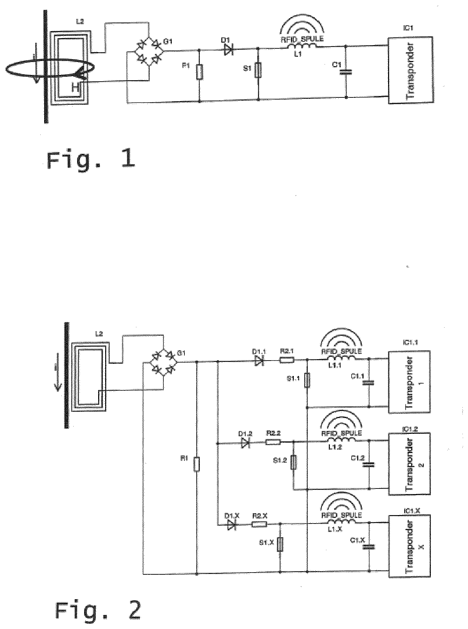

Wie in den Fig. 1, 2 und 3 dargestellt, erzeugt der durch eine Ableitung fließende Impulsstrom i in einer an oder in der Nähe der Ableitung angeordneten Spule L2 eine Induktionsspannung.

Über eine Graetz-Gleichrichterbrücke G1 und eine in Durchlassrichtung geschaltete Diode D1 wird diese Induktionsspannung an eine Schalteinrichtung, ausgeführt als Sicherung S1, gelegt.

Ist die in der Spule L2 eingekoppelte Energie höher als das Schmelzintegral der Sicherung S1, wird diese ausgelöst.

Im Ausgangszustand ist die Sicherung S1 unbelastet. Hierdurch ist der Antennenkreis, gebildet von der RFID-Spule L1 und dem RFID-Kondensator C1, der mit dem Transponder IC1 die RFID-Übertragung herstellt, geschlossen.

Wird S1 ausgelöst, findet ein Blocken einer Halbwelle der von der RFID-Spule L1 erzeugten Spannung über die Gleichrichterbrücke G1 und die Diode D1 statt.

Infolge dessen ist die Empfindlichkeit des Übertragungskanals zu einer (nicht gezeigten) Lesestation reduziert. Bei einer geringen Kopplung von Lesegerät und Transponderkreis wird so beim Öffnen der Sicherung S1 die Übertragung abgeschaltet.

Durch eine verbesserte Kopplung, z.B. Erhöhung der Sendeleistung des Lesegeräts, kann trotz unterbrochener Sicherung S1 wieder eine Kommunikation zum Transponder bzw. zum Lesegerät hergestellt werden. Vorteil ist hierbei, dass auch bei ausgelöster Impulsstromüberwachung die im Transponder abgelegten Informationen weiterhin ausgelesen werden können.

Ausgestaltend kann für die Spule L2 ein Ringkern verwendet werden, um die Empfindlichkeit der Impulsstromerkennung zu erhöhen. Der Ringkern kann auch aufklappbar oder mit einem beweglichen Schenkel ausgeführt werden, wie es bei sogenannten Stromzangen vorbekannt ist. Ebenfalls eignet sich eine kernlose Luftspule, insbesondere eine Rogowski-Spule, um die Induktivität L2 möglichst anwenderfreundlich umzusetzen.

Eine beispielhafte Dimensionierung für die Überwachung des Ableitstroms bei Überspannungsschutzgeräten geht von einer RFID-Spule L1 mit L=7,4 mH und N = 480 Windungen aus.

Die Spule L2 weist beispielhaft eine Induktivität L=1,1 µH mit N = 12 Windungen über Ringkern auf.

Als Sicherung S1 findet eine Schurter MAG FF, 200 mA Verwendung.

Mit der vorstehend beschriebenen Dimensionierung ergibt sich eine Auslösung der Sicherung bei einem Impulsstrom 8/20µs in Höhe von ca. 4,3 kA.

Die Auslöseschwelle kann über einen weiten Bereich verändert werden, indem bestimmte Sicherungstypen hinsichtlich Auslösestrom und Charakteristik ausgewählt werden. Ein weiterer wesentlicher Parameter ist die Windungszahl, die Fläche der Windung, das Kernmaterial für die Spule L2 und die Vorgabe des Widerstandswerts R1, der ausgangsseitig der Graetz-Brücke G1 geschaltet ist.

Durch die getrennte Anordnung der Antennenkreisspule L1 und der Impulsstrom-Spule L2 gemäß Fig. 1 ist es möglich, den Ableitpfad für den Impulsstrom in den unterschiedlichen Ausführungen mit der Auswerteeinrichtung zu koppeln.

Um nicht auf einen Schwellwert des im Leiter fließenden Stoßstroms i festgelegt zu sein, wird gemäß Fig. 2 eine Aufteilung der über die Spule L2 generierten Energie auf mehrere Schaltelemente bzw. Sicherungen S1.1 bis S1.x vorgeschlagen, um eine einfache Bewertung des im Leiter auftretenden Stoßstroms vornehmen zu können.

Gemäß der Darstellung nach Fig. 2 wird ausgangsseitig der Graetz-Gleichrichterbrücke G1 hinter dem Widerstand R1 ein Knoten gebildet, an dem im gezeigten Beispiel drei Dioden D1.1, D1.2 und D1.x vorhanden sind. In Serie zu den Dioden D1.1, D1.2 und D1.x ist jeweils ein Widerstand R2.1, R2.2 und R2.x angeschlossen, welcher dann auf die in jedem Zweig vorhandene Sicherung S1.1, S1.2 und S1.x führt. Für jede der vorgenannten Sicherungen wird ein eigener RFID-Kreis IC1.1, IC1.1 und IC1.x gebildet. Jeder RFID-Kreis enthält eine RFID-Spule L1.1, L1.2 und L1.x mit entsprechendem Antennenkreis-Kondensator C1.1, C1.2 und C1.x.

Allein durch eine parallele Schaltung von Sicherungen als Schalteinrichtungen mit unterschiedlichen Auslöseströmen lassen sich keine Schwellen einstellen. Grund hierfür ist die umgekehrte Proportionalität zwischen Auslösestrom und Widerstand einer Sicherung. Um die notwendigen Schwellwertschalter zu realisieren, werden dann alle Sicherungen S1.x mit gleichem Auslösestrom ausgeführt, wobei die Aufteilung des Auslösestroms über die Widerstände R2.1, R2.2 und 2.x vorgenommen wird. Je niedriger der Widerstandswert R2.x ist, desto höher ist der in diesem Zweig fließende Teilstrom, so dass die zugeordnete Sicherung dann bei der niedrigsten Schwelle auslöst.

Das Ansprechen der einzelnen RFID-Kreise kann über die sogenannte AOR (Answer On Request)-Funktion vorgenommen werden, welche von am Markt verfügbaren Transpondern geboten wird. Alternativ ist auch eine unterschiedliche Auslegung der Trägerfrequenz für die verschiedenen RFID-Kreise denkbar.

Die vorerwähnt erläuterten Ausführungsbeispiele gemäß den Fig. 1 und 2 ermöglichen die einmalige Registrierung des Überschreitens einer oder mehrerer Schwellwertstufen. Eine Zählung von Ereignissen ist jedoch nicht möglich.

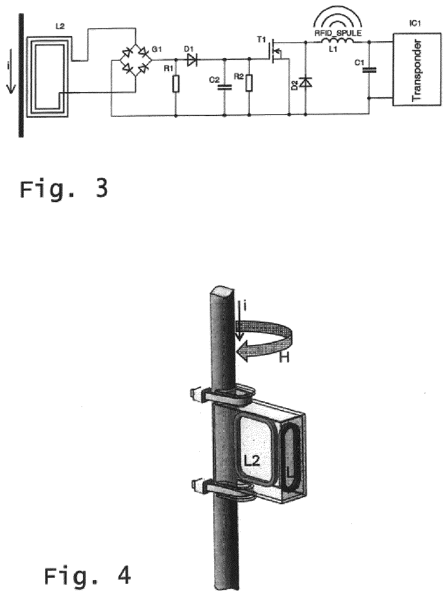

Ersetzt man, wie in der Fig. 3 dargestellt, erfindungsgemäß die Sicherung durch einen elektronischen Schalter, ausgebildet als selbstleitender MOSFET T1, kann für eine bestimmte Zeit der Antennenkreis des Transponders IC1 unterbrochen werden. Nach einer über die Zeitkonstante R2, C2 einstellbaren Zeit wird der Antennenkreis wieder geschlossen.

Wird über eine Leseeinrichtung eine kontinuierliche Abfrage des Transponders IC1 durchgeführt, kann eine Zähleinrichtung für das Auftreten von Impulsen realisiert werden. Voraussetzung ist, dass die Lese- und Auswerteeinrichtung mit einem Abfrageintervall kleiner als die Zeitkonstante des elektronischen Schalters T1 arbeitet. C2 und R2 sind als Parallelschaltungen am Steuereingang des elektronischen Schalters T1 angeordnet.

Mit der Prinzipschaltung nach Fig. 3 kann eine Registrierung eines Ableitstroms in einer Fangeinrichtung einer Blitzschutzanlage erfolgen. Dafür ist die Impulsüberwachung mit RFID-Transponder in einem Gehäuse untergebracht, welches an einer Fangeinrichtung oder einer entsprechenden Ableitung befestigbar ist.

Die Orientierung der Spule L2 wird so gewählt, dass das Magnetfeld H (siehe auch Fig. 4), verursacht durch den Stoßstrom i, die Wickelfläche der Spule durchdringt.

Die Wickelfläche der RFID-Antennenkreisspule L1 ist so angeordnet, dass durch das Magnetfeld H des Impulsstroms möglichst keine Induktion erfolgt.

Eine derartige prinzipielle Anordnung der Spulen L1 und L2 zeigt die Fig. 4.

Hierbei stehen die Wickelflächenebenen der Spulen L1 und L2 im Wesentlichen senkrecht zueinander.

Das Magnetfeld H durchdringt die Ebene der Spulenfläche der Spule L2 quasi senkrecht, so dass eine maximale Induktion gegeben ist.

Das Auslesen der vorliegenden passiven RFID-Transponder wird mit einer induktiv gekoppelten Spannungsversorgung über L1 und einer nicht gezeigten Leseeinrichtung durchgeführt.

Für diese Maßnahme sind keine elektrischen Verbindungen notwendig. Es kann daher die Schaltung für die Impulsüberwachung in einem Gehäuse hermetisch geschlossen und wettergeschützt untergebracht werden, was für die Anordnung an Fangeinrichtungen besonders vorteilhaft ist.

Die Auswerte- und Leseeinrichtung wird abgesetzt in einem separaten Gehäuse untergebracht. Je nach Wahl des Übertragungsverfahrens und den Eigenschaften der Spule L1 können definierte Entfernungen überbrückt werden. Bei der Verwendung von RFID-Transpondern mit AOR-Funktion kann die Abfrage mehrerer Fangeinrichtungen über eine einzige Auswerteeinrichtung erfolgen.

## Patentansprüche

1. Schaltungsanordnung geeignet für eine Zustandskontrolle und Protokollierung von Überspannungsschutzgeräten oder Überspannungsschutzanlagen mittels Impulsstromüberwachung, umfassend mindestens einen RFID-Transponder mit induktiv gekoppelter Spannungsversorgung, wobei im Ereignisfall des Überspannungsschutzgeräts oder der Überspannungsschutzanlage der RFID-Transponder-Antennenkreis beeinflusst, insbesondere unterbrochen, kurzgeschlossen oder verstimmt wird, so dass Störvorgänge identifizierbar sind,
**dadurch gekennzeichnet, dass**
an einer auftretende Impulsströme führenden Ableitung des Überspannungsschutzgeräts oder der Überspannungsschutzanlage eine Spule (L2) vorgesehen ist, welche derart orientiert ist, dass das Impulsstrom-bedingte Feld die Spulenwickelfläche durchdringt und eine Induktionsspannung erzeugt, wobei die Spule (L2) mit mindestens einer Schalteinrichtung in Verbindung steht, welche am Antennenkreis des RFID-Transponders mit der dortigen Induktivität (L1) angeschlossen ist, um den Antennenkreis mindestens zeitweise zu beeinflussen, wobei die Schalteinrichtung als Transistor (T) ausgeführt ist, wobei mittels eines im Steuerzweig des Transistors (T) angeordneten RC-Gliedes eine Zeitkonstante einstellbar ist, um den unterbrochenen Antennenkreis wieder zu schließen oder die Beeinflussung des Antennenkreises aufzuheben.

2. Schaltungsanordnung nach Anspruch 1,
**dadurch gekennzeichnet, dass**
die Spule (L2) mit einer Graetz-Gleichrichterbrücke (G1) in Verbindung steht, welche ausgangsseitig über eine Diode (D1) an der Schalteinrichtung (T) angeschlossen ist, wobei die Schalteinrichtung (T) im unbelasteten Ausgangszustand den Antennenkreis des RFID-Transponders, umfassend die Induktivität (L1) und eine Kapazität (C1) geschlossen hält.

3. Schaltungsanordnung nach Anspruch 1 oder 2,
**dadurch gekennzeichnet, dass**
die Schalteinrichtung als MOSFET ausgeführt ist.

4. Schaltungsanordnung nach einem der vorangegangenen Ansprüche,
**dadurch gekennzeichnet, dass**
die Spule (L2) als Ringkernspule oder kernlose Luftspule, insbesondere Rogowski-Spule ausgebildet ist.

## Claims

1. Circuit arrangement adapted for state monitoring or logging of overvoltage protection devices or overvoltage protection systems by means of pulse current monitoring, comprising at least one RFID transponder having an inductively coupled power supply, wherein, in case of an event of the overvoltage protection device or the overvoltage protection system, the antenna circuit of the RFID transponder is influenced, in particular interrupted, short-circuited or detuned, so that disturbance processes can be identified,
**characterized in that**
a coil (L2) is provided on an arrester of the overvoltage protection device or overvoltage protection system which arrester carries arising pulse currents, which coil is oriented such that the field caused by the pulse currents penetrates the coil winding surface and generates an induction voltage, wherein the coil (L2) is in communication with at least one switching means which is connected to the antenna circuit of the RFID transponder having the local inductance (L1) so as to influence the antenna circuit at least temporarily, wherein the switching means is realized as a transistor (T), wherein a time constant can be set by means of an RC member arranged in the control branch of the transistor (T) in order to close the interrupted antenna circuit again or to cancel the influencing of the antenna circuit.

2. Circuit arrangement according to claim 1,
**characterized in that**
the coil (L2) is in communication with a Graetz rectifier bridge (G1) which is connected on the output side to the switching means (T) via a diode (D1), wherein the switching means (T), in the unloaded initial state, keeps the antenna circuit of the RFID transponder, comprising the inductance (L1) and a capacitance (C1), closed.

3. Circuit arrangement according to claim 1 or 2,
**characterized in that**
the switching means is realized as a MOSFET.

4. Circuit arrangement according to anyone of the preceding claims,
**characterized in that**
the coil (L2) is formed as a toroidal core coil or a coreless air coil, in particular Rogowski coil.

## Revendications

1. Circuiterie appropriée pour contrôler l'état et établir un compte-rendu d'appareils de protection contre la surtension ou d'installations de protection contre la surtension au moyen d'une surveillance des impulsions de courant,
comportant
au moins un transpondeur RFID avec une alimentation en tension couplée par voie inductive,
dans laquelle, en cas d'événement de l'appareil de protection contre la surtension ou de l'installation de protection contre la surtension, le circuit d'antenne de transpondeur RFID est influencé, en particulier coupé, court-circuité ou désaccordé, de manière à pouvoir identifier des phénomènes de perturbation,
**caractérisée en ce que**
une bobine (L2) est prévue sur une ligne de dérivation, menant des impulsions de courant apparues, de l'appareil de protection contre la surtension ou de l'installation de protection contre la surtension, bobine qui est orientée de telle sorte que le champ dû aux impulsions de courant traverse la surface d'enroulement de la bobine et génère une tension d'induction, la bobine (L2) étant en connexion avec au moins un moyen de commutation qui est branché au circuit d'antenne du transpondeur RFID par l'inductivité (L1) prévue sur celui-ci, afin d'influencer au moins temporairement le circuit d'antenne, le moyen de commutation étant réalisé sous forme de transistor (T), et une constante temporelle est réglable à l'aide d'un circuit RC agencé dans la branche de commande du transistor (T), afin de fermer le circuit d'antenne coupé ou d'annuler l'influence du circuit d'antenne.

2. Agencement de circuit selon la revendication 1,
**caractérisé en ce que**
la bobine (L2) est en connexion avec un pont redresseur de Graetz (G1) qui est branché du côté sortie au moyen de commutation (T) via une diode (D1), le moyen de commutation (T) maintenant fermé le circuit d'antenne du transpondeur RFID comportant l'inductivité (L1) et une capacité (C1), dans l'état initial non chargé.

3. Agencement de circuit selon la revendication 1 ou 2,
**caractérisé en ce que**
le moyen de commutation est réalisé sous forme de MOSFET.

4. Agencement de circuit selon l'une des revendications précédentes,
**caractérisé en ce que**
la bobine (L2) est réalisée sous forme de bobine toroïdale ou sous forme de bobine à air sans noyau, en particulier sous forme de bobine de Rogowski.
